# EUROPÄISCHE PATENTANMELDUNG

(11) **EP 4 266 353 A1**
(43) Veröffentlichungstag der Anmeldung: **25.10.2023**
(21) Anmeldenummer: 22168953.2
(22) Anmeldetag: 20.04.2022
(51) Int. Cl.: H01L 21/306

(54) **VERFAHREN ZUM REINIGEN EINER HALBLEITERSCHEIBE NACH EINER POLITUR MITTELS CMP IN EINER REINIGUNGSSTRASSE**

(71) Anmelder: Siltronic AG, 81677 München (DE)
(72) Erfinder: Möckel, Bertram, 09599 Freiberg (DE); Rothenaicher, Simon, 84567 Erlbach (DE); Schwab, Günther, 84524 Neuötting (DE)
(74) Vertreter: Staudacher, Wolfgang

(57) **Zusammenfassung**

Verfahren zum Reinigen einer Halbleiterscheibe nach einer Politur mittels CMP in einer Reinigungsstrasse, die an eine Vorrichtung zum Durchführen der Politur angeschlossen ist, wobei die Reinigungstrasse mindestens zwei Reinigungsbehälter umfasst, in die die Halbleiterscheibe gebracht wird, so dass eine Vorderseite und eine Rückseite der Halbleiterscheibe Innenwänden des jeweiligen Reinigungsbehälters gegenüberliegen, und in denen die Halbeiterscheibe mit einem flüssigen Reinigungsmittel behandelt wird, dadurch gekennzeichnet, dass die Vorderseite und die Rückseite der Halbleiterscheibe während eines Reinigungsschritts in einem Reinigungsbehälter der Reinigungsstrasse mit DI-Wasser, das mit Ozon angereichert ist, als Reinigungsmittel gereinigt werden, und während eines anderen Reinigungsschritts in einem anderen Reinigungsbehälter der Reinigungsstrasse in Gegenwart von wässeriger Flusssäure als Reinigungsmittel gereinigt werden.

## Beschreibung

Gegenstand der Erfindung ist ein Verfahren zum Reinigen einer Halbleiterscheibe nach einer Politur mittels CMP in einer Reinigungsstrasse, die an eine Vorrichtung zum Durchführen der Politur angeschlossen ist, wobei die Reinigungstrasse mindestens zwei Reinigungsbehälter umfasst, in die die Halbleiterscheibe gebracht wird, so dass eine Vorderseite und eine Rückseite der Halbleiterscheibe Innenwänden des jeweiligen Reinigungsbehälters gegenüberliegen, und in denen die Halbeiterscheibe mit einem flüssigen Reinigungsmittel behandelt wird.

### Stand der Technik / Probleme

US2006 0 254 715 A1 und US6 406 359 sind beispielsweise Quellen, in denen ein solches Verfahren zum Reinigen einer Halbleiterscheibe bereits beschrieben ist.

Gemäß US2006 0 042 654 A1 und JP2002 110 602 werden Halbleiterscheiben aus einkristallinem Silizium nach einer Politur mittels CMP (chemical mechanical polishing) mit DI-Wasser (deionisiertem Wasser) behandelt, das mit Ozon angereichert ist.

Aufgabe der vorliegenden Erfindung ist es, eine effizientere Reinigung bereitzustellen.

Die Aufgabe der Erfindung wird gelöst durch ein Verfahren zum Reinigen einer Halbleiterscheibe nach einer Politur mittels CMP in einer Reinigungsstrasse, die an eine Vorrichtung zum Durchführen der Politur angeschlossen ist, wobei die Reinigungstrasse mindestens zwei Reinigungsbehälter umfasst, in die die Halbleiterscheibe gebracht wird, so dass eine Vorderseite und eine Rückseite der Halbleiterscheibe Innenwänden des jeweiligen Reinigungsbehälters gegenüberliegen, und in denen die Halbeiterscheibe mit einem flüssigen Reinigungsmittel behandelt wird, dadurch gekennzeichnet, dass die Vorderseite und die Rückseite der Halbleiterscheibe während eines Reinigungsschritts in einem Reinigungsbehälter der Reinigungsstrasse mit DI-Wasser, das mit Ozon angereichert ist, als Reinigungsmittel gereinigt werden, und während eines anderen Reinigungsschritts in einem anderen Reinigungsbehälter der Reinigungsstrasse in Gegenwart von wässeriger Flusssäure als Reinigungsmittel gereinigt werden.

Die wässerige Flusssäure als Reinigungsmittel enthält vorzugsweise ein Tensid, um die Benetzung der Halbleiterscheibe mit dem Reinigungsmittel zu fördern. Die Konzentration des Tensids beträgt vorzugsweise nicht mehr als 0,5 Vol.-%.

Die Halbleiterscheibe wird von oben in einen Reinigungsbehälter geladen, vorzugsweise durch einen Roboter, der einen die Halbleiterscheibe haltenden Greifarm bewegt. Die Halbleiterscheibe ist dabei vertikal im Raum angeordnet, so dass nach dem Beladen die Vorderseite und die Rückseite der Halbleiterscheibe Innenwänden des Reinigungsbehälters gegenüberliegen. Im Zuge der Reinigung wird die Halbleiterscheibe von einem Reinigungsbehälter zum Reinigungsbehälter des nachfolgenden Reinigungsschritts gehoben. Um zu vermeiden, dass dabei Reinigungsmittel unbeabsichtigt von der Halbeiterscheibe in ein Reinigungsbehälter tropft, in dem der nachfolgende Reinigungsschritt nicht vorgesehen ist, sind die Reinigungsbehälter vorzugsweise so angeordnet, dass der nachfolgende Reinigungsschritt in einem Reinigungsbehälter erfolgt, der dem Reinigungsbehälter des aktuellen Reinigungsschritts unmittelbar benachbart ist.

Am Ende der Reinigungsstrasse befindet sich vorzugsweise eine Vorrichtung, in der die gereinigte Halbleiterscheibe getrocknet wird.

Vorzugsweise werden unmittelbar vor dem Trocknen der Halbleiterscheibe im Zuge eines letzten Reinigungsschritts die Vorderseite und die Rückseite der Halbleiterscheibe in einem Reinigungsbehälter der Reinigungsstrasse in Gegenwart von DI-Wasser abgebürstet.

Gemäß einer ersten bevorzugten Ausführungsform umfasst das Verfahren als ersten Reinigungsschritt das Besprühen der Vorderseite und der Rückseite der Halbleiterscheibe in einem ersten Reinigungsbehälter der Reinigungsstrasse mit DI-Wasser, das mit Ozon angereichert ist, als zweiten Reinigungsschritt das Abbürsten der Vorderseite und der Rückseite der Halbleiterscheibe in einem zweiten Reinigungsbehälter der Reinigungsstrasse in Gegenwart von wässeriger Flusssäure als Reinigungsmittel, und als dritten Reinigungsschritt das Besprühen der Vorderseite und der Rückseite der Halbleiterscheibe in einem dritten Reinigungsbehälter der Reinigungsstrasse mit DI-Wasser, das mit Ozon angereichert ist. Der erste Reinigungsschritt der ersten Ausführungsform kann anstelle einer Sprühreinigung auch eine Badreinigung in Gegenwart von DI-Wasser, das mit Ozon angereichert ist, umfassen. Der zweite Reinigungsschritt der ersten Ausführungsform kann anstelle einer Bürstenreinigung auch als Badreinigung in Gegenwart von wässeriger Flusssäure ausgestaltet sein, und es kann gleichzeitig zur Bürstenreinigung das Besprühen der Vorderseite und der Rückseite der Halbleiterscheibe vorgesehen sein (kombinierte Bürstenreinigung und Sprühreinigung).

Gemäß einer zweiten bevorzugten Ausführungsform umfasst das Verfahren als ersten Reinigungsschritt das Abbürsten der Vorderseite und der Rückseite der Halbleiterscheibe in einem ersten Reinigungsbehälter der Reinigungsstrasse in Gegenwart von wässeriger Flusssäure als Reinigungsmittel, und als zweiten Reinigungsschritt das Besprühen der Vorderseite und der Rückseite der Halbleiterscheibe in einem zweiten Reinigungsbehälter der Reinigungsstrasse mit DI-Wasser, das mit Ozon angereichert ist. Der erste Reinigungsschritt der zweiten Ausführungsform kann anstelle einer Bürstenreinigung auch als Badreinigung in Gegenwart von wässeriger Flusssäure ausgestaltet sein, und es kann gleichzeitig zur Bürstenreinigung das Besprühen der Vorderseite und der Rückseite der Halbleiterscheibe vorgesehen sein (kombinierte Bürstenreinigung und Sprühreinigung). Der zweite Reinigungsschritt der zweiten Ausführungsform kann anstelle einer Sprühreinigung auch als Badreinigung in Gegenwart von mit Ozon angereichertem DI-Wasser ausgestaltet sein.

Vorzugsweise umfasst das Verfahren einen letzten Reinigungsschritt in einem letzten Reinigungsbehälter der Reinigungsstrasse, in dem die Vorderseite und die Rückseite der Halbleiterscheibe mit DI-Wasser als Reinigungsmittel abgebürstet werden. Gemäß der ersten Ausführungsform erfolgt dieser Reinigungsschritt nach dem dritten Reinigungsschritt und vor dem Trocknen der Halbleiterscheibe und gemäß der zweiten Ausführungsform nach dem zweiten Reinigungsschritt und vor dem Trocknen der Halbleiterscheibe.

Die nachfolgende Beschreibung nimmt auf eine Zeichnung Bezug. Die Darstellung beschränkt sich auf Merkmale, die für das Verständnis der Erfindung von Bedeutung sind.

### Kurzbeschreibung der Zeichnung

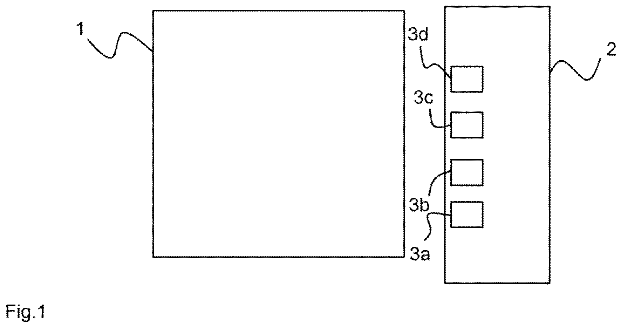

Fig. 1 zeigt in Draufsicht eine Polierstation mit angeschlossener Reinigungsstation, die zur Durchführung des Verfahrens geeignet ist.

### Liste der verwendeten Bezugszeichen

- **1**: Polierstation
- **2**: Reinigungsstation
- **3a**: Reinigungsbehälter
- **3b**: Reinigungsbehälter
- **3c**: Reinigungsbehälter
- **3d**: Reinigungsbehälter

### Detaillierte Beschreibung erfindungsgemäßer Ausführungsbeispiele

Fig.1 zeigt schematisch die Anordnung einer Polierstation 1 und einer Reinigungsstation 2, die beispielsweise vier Reinigungsbehälter 3a bis 3d umfasst. Die vier Reinigungsbehälter bilden eine Reinigungsstrasse, in der eine Halbleiterscheibe nach der CMP in der Polierstation gereinigt wird. Die Polierstation umfasst mindestens einen Polierkopf, der eine zu polierende Halbleiterscheibe während der Politur gegen ein Poliertuch presst. Nicht dargestellt sind Roboter, die eine polierte Halbleiterscheibe von der Polierstation zur Reinigungsstation transportieren und die die polierte Halbleiterscheibe in die Reinigungsbehälter hinein- und herausheben. Nicht dargestellt ist auch eine Trocknungsstation, in der die Halbleiterscheibe nach der Reinigung getrocknet wird, der Behälter, in dem die getrocknete Halbleiterscheibe eingelagert wird.

Die Halbleiterscheibe durchläuft nach der CMP eine Sequenz von Reinigungsschritten. Während eines jeden Schritts der Reinigungssequenz wird die Halbleiterscheibe mit einem flüssigen Reinigungsmittel behandelt. Während der Behandlung mit dem Reinigungsmittel wird die Halbleiterscheibe vertikal stehend einer Einzelscheiben-Behandlung unterzogen. Gegebenenfalls steht sie auf Rollen und wird um ihr Zentrum gedreht. Die Reihenfolge der Reinigungssequenz kann mit der Reihenfolge der Anordnung der Reinigungsbehälter übereinstimmen, muss aber nicht. Jeder Reinigungsbehälter ist entweder als Badreinigung, als Sprühreinigung und/oder als Bürstenreinigung ausgestaltet. Bei der Badreinigung wird die Halbleiterscheibe ins Reinigungsmittel getaucht, bei der Sprühreinigung werden Vorder- und Rückseite der Halbleiterscheibe mit dem Reinigungsmittel besprüht und bei der Bürstenreinigung wird das Reinigungsmittel mittels sich drehender Bürsten auf der Vorder- und Rückseite der Halbleiterscheibe verteilt. Die Reinigung im Reinigungsbad kann durch Einstrahlen von Megaschall-Wellen unterstützt sein.

Eine erfindungsgemäße Reinigungssequenz umfasst vorzugsweise drei oder vier Reinigungsschritte, die in den Reinigungsbehältern 3a bis 3d beispielsweise in der Reihenfolge der Anordnung der Reinigungsbehälter durchgeführt werden.

Gemäß der ersten Ausführungsform umfasst das Verfahren als ersten Reinigungsschritt eine Sprühreinigung der Halbleiterscheibe im ersten Reinigungsbehälter 3a, wobei das Reinigungsmittel mit Ozon angereichertes DI-Wasser ist. Der zweite Reinigungsschritt wird im zweiten Reinigungsbehälter 3b als Bürstenreinigung oder als Badreinigung durchgeführt, wobei das Reinigungsmittel wässerige Flusssäure ist, die vorzugsweise ein Tensid enthält. Der dritte Reinigungsschritt ist eine weitere Sprühreinigung mit DI-Wasser, das mit Ozon angereichert ist, die im Reinigungsbehälter 3c durchgeführt wird. Gegebenenfalls folgt ein letzter Reinigungsschritt mit DI-Wasser im Reinigungsbehälter 3d bevor die Halbleiterscheibe getrocknet wird. Dieser letzte Reinigungsschritt wird als Bürstenreinigung durchgeführt.

Gemäß der zweiten Ausführungsform umfasst das Verfahren als ersten Reinigungsschritt eine Bürstenreinigung oder eine Badreinigung der Halbleiterscheibe im ersten Reinigungsbehälter 3a, wobei das Reinigungsmittel wässerige Flusssäure ist, die vorzugsweise ein Tensid enthält. Der zweite Reinigungsschritt wird im zweiten Reinigungsbehälter 3b als Sprühreinigung oder als Badreinigung durchgeführt, wobei das Reinigungsmittel mit Ozon angereichertes DI-Wasser ist. Gegebenenfalls folgt ein dritter und letzter Reinigungsschritt mit DI-Wasser im Reinigungsbehälter 3c bevor die Halbleiterscheibe getrocknet wird. Dieser letzte Reinigungsschritt wird als Bürstenreinigung durchgeführt. In diesem Fall wird der Reinigungsbehälter 3d nicht benutzt oder ist nicht vorhanden.

Andererseits können neben den beschriebenen Reinigungsschritten der beiden bevorzugten Ausführungsformen ein oder mehrere weitere Reinigungsschritte vorgesehen sein, beispielsweise eine Badreinigung mit oder ohne Unterstützung durch Megaschall-Wellen. Die Reinigungsstrasse umfasst in diesem Fall die entsprechende zusätzliche Anzahl von Reinigungsbehältern.

## Patentansprüche

1. Verfahren zum Reinigen einer Halbleiterscheibe nach einer Politur mittels CMP in einer Reinigungsstrasse, die an eine Vorrichtung zum Durchführen der Politur angeschlossen ist, wobei die Reinigungstrasse mindestens zwei Reinigungsbehälter umfasst, in die die Halbleiterscheibe gebracht wird, so dass eine Vorderseite und eine Rückseite der Halbleiterscheibe Innenwänden des jeweiligen Reinigungsbehälters gegenüberliegen, und in denen die Halbeiterscheibe mit einem flüssigen Reinigungsmittel behandelt wird, **dadurch gekennzeichnet, dass** die Vorderseite und die Rückseite der Halbleiterscheibe während eines Reinigungsschritts in einem Reinigungsbehälter der Reinigungsstrasse mit DI-Wasser, das mit Ozon angereichert ist, als Reinigungsmittel gereinigt werden, und während eines anderen Reinigungsschritts in einem anderen Reinigungsbehälter der Reinigungsstrasse in Gegenwart von wässeriger Flusssäure als Reinigungsmittel gereinigt werden.

2. Verfahren nach Anspruch 1, **dadurch gekennzeichnet, dass** der Reinigungsschritt mit wässeriger Flusssäure als Reinigungsmittel als Bürstenreinigung oder als kombinierte Bürstenreinigung und Sprühreinigung oder als Badreinigung durchgeführt wird.

3. Verfahren nach Anspruch 1, **dadurch gekennzeichnet, dass** der Reinigungsschritt mit DI-Wasser als Reinigungsmittel, das mit Ozon angereichert als Sprühreinigung oder als Badreinigung durchgeführt wird.

4. Verfahren nach Anspruch 1 oder Anspruch 2, **dadurch gekennzeichnet, dass** die wässerige Flusssäure ein Tensid enthält.

5. Verfahren nach einem der Ansprüche 1 bis 4, **dadurch gekennzeichnet, dass** der Reinigungsschritt mit DI-Wasser als Reinigungsmittel, das mit Ozon angereichert ist, vor dem Reinigungsschritt mit wässeriger Flusssäure als Reinigungsmittel durchgeführt wird, und daran anschließend ein weiterer Reinigungsschritt in einem weiteren Reinigungsbehälter der Reinigungsstrasse durchgeführt wird, in dem die Vorderseite und die Rückseite der Halbleiterscheibe mit DI-Wasser als Reinigungsmittel, das mit Ozon angereichert ist, besprüht werden.

6. Verfahren nach einem der Ansprüche 1 bis 4, **dadurch gekennzeichnet, dass** der Reinigungsschritt mit wässeriger Flusssäure als Reinigungsmittel vor dem Reinigungsschritt mit DI-Wasser als Reinigungsmittel, das mit Ozon angereichert ist, durchgeführt wird.

7. Verfahren nach einem der Ansprüche 1 bis 6, **dadurch gekennzeichnet, dass** die Vorderseite und die Rückseite der Halbleiterscheibe während eines letzten Reinigungsschritts in einem letzten Reinigungsbehälter der Reinigungsstrasse mit DI-Wasser als Reinigungsmittel abgebürstet werden.

8. Verfahren nach einem der Ansprüche 1 bis 6, **dadurch gekennzeichnet, dass** die Halbleiterscheibe nach den Reinigungsschritten getrocknet wird.
